# EUROPÄISCHE PATENTSCHRIFT

(11) **EP 4 327 112 B1**
(45) Veröffentlichungstag und Bekanntmachung des Hinweises auf die Patenterteilung: **25.02.2026**
(21) Anmeldenummer: 22722440.9
(22) Anmeldetag: 12.04.2022
(51) Int. Cl.: G01R 31/392, G01R 31/396

(54) **ERMITTLUNG DES ALTERUNGSZUSTANDES EINES ENERGIESPEICHERS AN BORD EINES UNTERSEEBOOTES**
DETERMINING THE STATE OF HEALTH OF AN ENERGY STORE ON BOARD A SUBMARINE
DÉTERMINATION DE L'ÉTAT DE VIEILLISSEMENT D'UN ACCUMULATEUR D'ÉNERGIE À BORD D'UN SOUS-MARIN

(30) Priorität: 21.04.2021 DE 102021203947
(43) Veröffentlichungstag der Anmeldung: 28.02.2024
(73) Patentinhaber: TKMS GmbH, 24143 Kiel (DE); thyssenkrupp AG, 45143 Essen (DE)
(72) Erfinder: FRANK, Philip, 25746 Heide-Süderholm (DE); JOECKLE, Florent, 24242 Felde (DE); JEDTBERG, Holger, 24105 Kiel (DE)
(74) Vertreter: thyssenkrupp Intellectual Property GmbH
(86) Internationale Anmeldenummer: PCT/EP2022/059679
(87) Internationale Veröffentlichungsnummer: WO 2022/223357

(56) Entgegenhaltungen:
- DE-A1- 102009 038 663
- KR-A- 20190 043 212
- US-A1- 2021 044 119

## Beschreibung

Die Erfindung betrifft ein Verfahren zur konkreten Messung des Alterungszustandes eines Energiespeichers an Bord eines Unterseebootes.

Bisher werden Unterseeboote üblicherweise mit Energiespeichervorrichtung mit Akkumulatoren auf Blei-Basis (insbesondere Blei-Blei(IV)-Schwefelsäure) eingesetzt. Um die Kapazität dieser Energiespeichervorrichtungen zu testen wurden die Akkumulatoren während des Anschlusses an Land mit einem sehr geringen Ladestrom entladen.

Zunehmend werden jedoch Akkumulatoren mit anderen Technologien eingesetzt, beispielsweise und insbesondere Akkumulatoren auf Lithium-Basis. Bei dieses ist aber das Verhalten komplett anders, sodass diese besser mit einem hohen konstanten Strom entladen werden, welcher deutlich höher ist im Vergleich zu einem Akkumulator auf Blei-Basis. Dieses würde aber dazu führen, dass die durch einen Landanschluss abgegebene Strommenge deutlich größer wäre, als über einen Anschluss maximal fließen kann.

Für Unterseeboote kommt im Vergleich zu anderen Anwendungen, beispielsweise dem Automobil-Bereich hinzu, dass ein Ausbau oder Austausch der Akkumulatoren aufgrund des Aufwandes keine sinnvolle Option ist. Die Vermessung beispielsweise in einem Teststand ist somit nicht sinnvoll möglich. Die Prüfung muss also innerhalb des Unterseebootes mit den gegebenen Möglichkeiten erfolgen.

Aus der US 2021/044119 A1 ist ein Verfahren zur Durchführung einer Gesundheitszustandsschätzung für ein wiederaufladbares Batterie-Energiespeichersystem bekannt.

Aus der KR 2019 0043212 A ist eine Struktur und ein Verfahren zur Konstruktion der Sicherheit der Schichtbatterie für Unterseeboote bekannt.

Aus der DE 10 2009 038 663 A1 ist ein Kraftwagen mit einer Mehrzahl von Batterien und ein Verfahren zur Batteriediagnose bekannt.

Aufgabe der Erfindung ist es, ein neues Verfahren bereitzustellen, mit dem auch für Energiespeichervorrichtungen mit Akkumulatoren auf einer anderen Basis als der bisherigen Blei-Basis, insbesondere auf Lithium-Basis, die aktuelle maximale Kapazität und damit der Alterungszustand zuverlässig gemessen werden kann. Insbesondere soll dieses auch die immer kürzeren Hafenliegenzeiten berücksichtigen, sodass das Verfahren auch unabhängig von besonderen externen Vorrichtungen durchführbar ist.

Gelöst wird diese Aufgabe durch das Verfahren mit den in Anspruch 1 angegebenen Merkmalen. Vorteilhafte Weiterbildungen ergeben sich aus den Unteransprüchen, der nachfolgenden Beschreibung sowie den Zeichnungen.

Das erfindungsgemäße Verfahren dient zur Ermittlung des Alterungszustands (State of Health) einer Energiespeichervorrichtung an Bord eines Unterseebootes. Der Begriff Alterungszustand oder auch State of Health meint die alterungsabhängige jeweils aktuelle verfügbare Kapazität. Zum einen ergibt sich hieraus die Information der real in der Energiespeichervorrichtung maximal speicherbaren Energie. Zum anderen kann aus der Änderung eben auf die Alterung geschlossen werden, insbesondere sprunghafte Änderungen stellen ein Indiz für auftretende Probleme dar, sodass aus der Entwicklung der zeitabhängigen maximalen Kapazität eben Rückschlüsse auf den Alterungszustand möglich sind. Dieses erfolgt üblicherweise kontinuierlich auf vorhersagender Weise, indem ein Schiffs-Batteriemanagementsystem ein durchschnittliches Alterungsverhalten annimmt und dann die Anzahl und Art der Ladezyklen, Umgebungseinflüsse wie Temperatur und dergleichen berücksichtigt und dadurch dann die maximale Kapazität abschätzt. Jedoch hat ein solches Modell nur eine begrenzte Genauigkeit, sodass erfindungsgemäß von Zeit zu Zeit, beispielsweise einmal im Jahr, der exakte Zustand erfasst wird. Hierdurch kann das Modell zum einen auf den exakten ermittelten Startwert für die Zukunft gesetzt werden. Zum anderen kann es sogar möglich sein, dass Modell insgesamt anzupassen. Das Unterseeboot weist wenigstens eine erste Energiespeichervorrichtung auf, wobei die erste Energiespeichervorrichtung mehr als zwei Stränge, bevorzugt 10 bis 200 Stränge, aufweist. Hierbei bestehen die Stränge vorzugsweise aus zwei bis zehn, weiter bevorzugt aus vier bis acht Modulen. Jedes Modul weist eine Mehrzahl an Elementarzellen auf, die vorzugsweise teilweise in Reihe und teilweise parallel geschaltet sind. Die Module sind in einem Strang vorzugsweise in Reihe geschaltet. Jeder Strand kann vorzugsweise einzeln mit dem Bordnetz verbunden werden, sodass die Stränge parallel geschaltet werden können, um einen maximalen Strom entnehmen zu können.

Das erfindungsgemäße Verfahren weist die folgenden Schritte auf:
a) Einstellen eines Ladezustands der Energiespeichervorrichtung auf einen Wert von 45 bis 80 % der maximalen Kapazität, bevorzugt auf 45 bis 60% der maximalen Kapazität, besonders bevorzugt auf 47 bis 55% der maximalen Kapazität.
b) Aufteilen der Stränge auf Stranggruppen, wobei jede Stranggruppe nicht mehr als 50 % der Stränge enthält,
c) Auswählen einer ersten Stranggruppe zur Ermittlung des Alterungszustandes,
d) Vollständiges Laden der ersten Stranggruppe,
e) Halten der ersten Stranggruppe auf voller Ladung,
f) Vollständiges Entladen der ersten Stranggruppe bei konstantem Strom und Erfassung der Kapazität der ersten Stranggruppe,
g) Laden der ersten Stranggruppe.

Vorteil dieses Verfahrens ist, dass nur ein Teil der Stränge ausgewählt wird. Damit ist es möglich, den Entladestrom innerhalb des Bootes zu lenken und zu verbrauchen. Verbrauchen umfasst in diesem Zusammenhang insbesondere auch eine Verwendung zum Aufladen eines anderen Stranges oder einer anderen Stranggruppe. Eine Abgabe über einen Landanschluss entfällt damit. Des Weiteren ist vorteilhaft, dass so Teile der Energiespeichervorrichtung zu getrennten Zeit vermessen werden können. So kann beispielsweise bei einem Hafenaufenthalt jeweils nur eine Stranggruppe untersucht werden. Ist die Energiespeichervorrichtung beispielhaft in vier gleich große Stranggruppen unterteilt worden, so kann nach vier Liegezeiten im Hafen bei jeder Liegezeit eine Stranggruppe untersucht werden, sodass nach vier Liegezeiten alle Stränge untersucht wurden. Hierdurch ermöglicht das Verfahren eine optimale und störungsarme Integration in den normalen Bootsbetrieb und vermeidet somit längere Liegezeiten im Hafen. Ebenso könnte das Verfahren bei der Überwasser-Rückfahrt in den Hafen oder bei einer längeren Transferfahrt durchgeführt werden.

Das Aufteilen der Stränge in Stranggruppen gemäß Schritt b) kann beispielsweise einmalig beim Bau der Energiespeichervorrichtung erfolgen und somit fest vorgegeben sein. Es kann aber auch dynamisch erfolgen, beispielsweise wenn der Ladezustand sich auf einem höheren Ladezustand befindet, als gemäß Schritt a) eingestellt werden sollte. Kann also beispielsweise nur ein Ladzustand von im Mittel 75 % erreicht werden, so werden vorzugsweise vier bis sechs Stranggruppen gewählt, während bei 50 % Ladzustand vorzugsweise drei Stranggruppen gewählt werden.

Die Reihenfolge der Schritte a) und b) ist beliebig und insbesondere Schritt b) kann auch nur einmalig durchgeführt werden. Es kann aber sinnvoll sein, dass dennoch eine Überprüfung durchgeführt wird, ob eine Anpassung sinnvoll sein kann.

Zur Durchführung des Verfahrens weist das Unterseeboot typischer Weise eine Steuereinheit auf, die das Verfahren regelt. Beispielsweise versetzt die Steuereinheit die Stränge in einen entsprechenden Betriebsmodus. Weiter weist das Unterseeboot eine Auswerteeinheit auf, welche den Alterungszustand aus den gemessenen Strömen ermittelt, auswertet, speichert und zeitlich vergleicht, Die Auswerteeinheit kann auch über ein Prognosemodul verfügen, dass den Alterungszustand zwischen zwei Messungen aufgrund eines in der Auswerteeinheit hinterlegten Rechenmodels vorhersagt.

Vorzugsweise weist jeder Strang ein Strang-Batteriemanagementsystem auf, welches in der Lage ist, die in den Strang fließenden Ströme und die aus dem Strang fließenden Ströme zu erfassen. Dabei kann auch vorgesehen sein, dass zusätzlich eine Spannung am Ausgang des Strangs gemessen wird.

In einer weiteren Ausführungsform der Erfindung werden die Schritte d) bis g) für die Stränge der ersten Stranggruppe jeweils für den Strang unabhängig von den anderen Strängen durchgeführt. Praktisch bedeutet dieses, dass sobald ein Strang der ersten Stranggruppe in Schritt d) vollständig geladen ist, für diesen Strang die Ladung in Schritt e) gehalten wird und anschließend in Schritt f) der Strang entladen wird. Es kann also beispielsweise sein, dass der Strang der ersten Stranggruppe, welcher eine höhere Restladung aufwies, somit schneller die Schritte durchläuft als ein anderer Strang der ersten Stranggruppe, welcher eine geringere Restlandung am Beginn des Verfahrens aufwies. Dadurch kann es für die einzelnen Stränge zu einem zeitlichen Nebeneinander der Schritte d) bis g) kommen, während die Schritte a) bis c) parallel für alle Stränge gemeinsam erfolgen und der Schritt d) ebenfalls für alle Stränge der ersten Stranggruppe gestartet wird.

Während der Durchführung des erfindungsgemäßen Verfahrens können die weiteren Bootssysteme insbesondere auf drei Arten zuverlässig und unabhängig mit Energie versorgt werden. In einer ersten Ausführungsform wird das Unterseeboot über einen Landanschluss, mit Energie versorgt. In einer zweiten Ausführungsform gibt es zwei Energiespeichervorrichtungen, von denen eine Energiespeichervorrichtung das erfindungsgemäße Verfahren durchführt und die andere Energiespeichervorrichtung das Boot mit Energie versorgt. In einer dritten Ausführungsform weist die Energiespeichervorrichtung drei Stranggruppen auf, von denen eine erste Stranggruppe das erfindungsgemäße Verfahren durchführt, eine zweite Stranggruppe dient als Quelle oder Senke für die Energie der ersten Stranggruppe für das Verfahren und die dritte Stranggruppe versorgt das Boot mit Energie.

In einer weiteren Ausführungsform der Erfindung weist das Verfahren zusätzlich die folgenden Schritte auf:
h) Auswählen einer zweiten Stranggruppe zur Ermittlung des Alterungszustandes,
i) Vollständiges Laden der zweiten Stranggruppe,
j) Halten der zweiten Stranggruppe auf voller Ladung,
k) Vollständiges Entladen der zweiten Stranggruppe bei konstantem Strom und Erfassung der Kapazität der zweiten Stranggruppe,
l) Laden der zweiten Stranggruppe

Ist die zur Verfügung stehende Zeit ausreichend, so kann selbstverständlich das Verfahren mit einer zweiten Stranggruppe fortgesetzt werden. Alternativ kann die zweite Stranggruppe wie bereits beschrieben auch zu einem späteren Zeitpunkt vermessen werden.

Steht ausreichend Zeit zur Verfügung kann das Verfahren für alle weiteren Stranggruppen fortgesetzt werden, wodurch einmalig der exakte Zustand für alle Stränge gleichzeitig ermittelt werden kann.

Analog den Schritten d) bis g) können auch die Schritte i) bis l) für die einzelnen Stränge der zweiten Stranggruppe jeweils individuell durchgeführt werden, sodass es auch für die einzelnen Stränge zu einem zeitlichen Nebeneinander der Schritte i) bis l) kommen kann.

In einer weiteren Ausführungsform der Erfindung wird bei einem Fehler in einem Strang das Verfahren für die Stranggruppe fortgesetzt und nur der betroffene Strang wird aus der Stranggruppe genommen. Hierdurch wird für die weiteren Stränge der Stranggruppe noch ein Messwert erhalten und die Zeit somit genutzt. Der Strang, bei dem ein Fehler aufgetreten ist, wird üblicherweise zunächst getrennt und untersucht. Fehler ist im Sinne der Erfindung hier weit auszulegen und umfasst neben klassischen Fehlermeldungen auch beispielsweise ein Überschreiten einer Temperatur, beispielsweise im Kühlwasser. Ebenso kann ein Temperatursensor, der ein thermisches Durchgehen detektieren soll einen Alarm ausgelöst haben, sodass zunächst zu prüfen ist, ob eine der Elementarzellen eine Beschädigung aufweist. Somit umfasst Fehler in diesem Zusammenhang auch beispielsweise Umgebungstemperaturen, die für den normalen Betrieb völlig unkritisch sind, für eine genaue Messung der Kapazität aber insbesondere zu hoch liegen.

In einer weiteren Ausführungsform der Erfindung stellen die Stranggruppen bis auf die ausgewählte Stranggruppe in Schritt d) beziehungsweise Schritt i) die Energie zum vollständigen Aufladen des ausgewählten Stranggruppe die Energie bereit und nehmen in Schritt f) beziehungsweise in Schritt k) die Energie aus der ausgewählten Stranggruppe auf. Vorteil der Ausführungsform ist, dass eine elektrische Energie nur innerhalb der Energiespeichervorrichtung umgewandelt wird. Hierdurch kann das Verfahren vollständig unabhängig von den weiteren Schiffseinrichtungen oder einem Landanschluss durchgeführt werden.

**In** einer weiteren Ausführungsform der Erfindung wird die erste Energiespeichervorrichtung vor dem Beginn des Verfahrens vom Bordnetz des Unterseebootes getrennt. Besonders bevorzugt erfolgt dieses in Kombination mit der Ausführungsform, dass die Stranggruppen bis auf den ausgewählten Stranggruppe in Schritt d) beziehungsweise Schritt i) die Energie zum vollständigen Aufladen des ausgewählten Stranggruppe die Energie bereitstellen und nehmen in Schritt f) beziehungsweise in Schritt k) die Energie aus der ausgewählten Stranggruppe aufnehmen.

**In** einer weiteren Ausführungsform der Erfindung wird die Temperatur der ersten Energiespeichervorrichtung in einem Bereich gehalten, der eine genügend hohe Genauigkeit der Strommessung ermöglicht, beispielsweise und insbesondere einen Bereich von 15 °C bis 35 °C gehalten. Besonders bevorzugt wird das Verfahren nicht begonnen, wenn die Temperatur der Energiespeichervorrichtung außerhalb dieses Bereiches liegt.

**In** einer weiteren Ausführungsform der Erfindung werden die Schritte d) bis f) nach Schritt f) beziehungsweise die Schritte i) bis k) nach Schritt k) wiederholt. Hierdurch verdoppelt sich zwar die Messzeit, jedoch kann hierdurch nicht nur der Messwert genauer bestimmt werden, gleichzeitig ist aus der Stärke der Abweichung auch ein zusätzlicher Indikator für abweichendes Verhalten zu entnehmen, was eine schlechte Vorhersagemöglichkeit durch ein konventionelles Prognosemodell vorhersagt.

**In** einer weiteren Ausführungsform der Erfindung weist das Unterseeboot eine zweite Energiespeichervorrichtung auf. Das erfindungsgemäße Verfahren wird auch für die zweite Energiespeichervorrichtung durchgeführt.

**In** einer weiteren Ausführungsform der Erfindung weist das Unterseeboot eine zweite Energiespeichervorrichtung auf. Während der Durchführung des erfindungsgemäßen Verfahrens für die erste Energiespeichervorrichtung wird gleichzeitig das Verfahren auch für die zweite Energiespeichervorrichtung durchgeführt. Diese Ausführungsform ist bevorzugt, wenn das Unterseeboot beispielsweise über einen Landanschluss mit Strom versorgt wird. Ebenso kann diese Ausführungsform bevorzugt sein, wenn das Unterseeboot bei einer Überwasserfahrt durch einen Dieselgenerator mit Energie versorgt wird.

Besonders bevorzugt sind in einer Weiterbildung dieser Ausführungsform beide Energiespeichervorrichtungen jeweils separat und vom Bordnetz getrennt. Das Verfahren wird somit für beide Energiespeichervorrichtungen jeweils getrennt und völlig unabhängig von den restlichen Schiffssystemen durchgeführt. Die elektrische Energie des Verfahrens verbleibt somit jeweils in der betreffenden Energiespeichervorrichtung.

In einer weiteren alternativen Ausführungsform der Erfindung wird das Verfahren für die erste Energiespeichervorrichtung durchgeführt, während die zweite Energiespeichervorrichtung die Energieversorgung für das Unterseeboot bereitstellt. Hierdurch wird eine vollständige Unabhängigkeit von einem Landanschluss oder einem Dieselgenerator erreicht, der beispielsweise in einem Hafen, der nicht über einen Landanschluss verfügt.

In einer weiteren Ausführungsform der Erfindung kann das Verfahren weder manuell noch automatisch durchgeführt werden, während sich das Unterseeboot im Kampfmodus befindet. Hierdurch wird sichergestellt, dass in einer solches Situation stets das Maximum an Energie zur Verfügung gestellt werden kann.

In einer weiteren Ausführungsform der Erfindung kann das Verfahren zu jedem Zeitpunkt unmittelbar unterbrochen werden und somit die Energiespeichervorrichtung jede zu diesem Zeitpunkt bereitstehende Energie unmittelbar zur Verfügung stellen. Diese Ausführungsform ist bevorzugt, wenn beispielsweise die Energie für den Betrieb des Unterseebootes benötigt wird oder wenn unverzüglich Kampfbereitschaft hergestellt werden soll.

In einer weiteren Ausführungsform der Erfindung wird bei einem Abbruch des Verfahrens zunächst ein Ausgleich der Ladezustände der Stränge durchgeführt, bevor die Energiespeichervorrichtung die Energie über das Bordnetz abgibt. Hierdurch wird ermöglicht, das die Energie mit möglichst voller Leistung zur Verfügung steht. Diese Ausführungsform ist bevorzugt, wenn langfristig absehbar ist, dass das Verfahren beispielsweise aufgrund geänderter Randparameter nicht beendet werden kann, beispielsweise, weil das Auslaufen aus dem Hafen vorverlegt wurde.

In einer weiteren Ausführungsform der Erfindung werden die Stränge, welche einen Fehler oder Defekt aufweisen bei der Aufteilung in Schritt b) nicht berücksichtig und werden somit nicht für das Verfahren verwendet.

Nachfolgend ist das erfindungsgemäße Verfahren anhand eines in den Zeichnungen dargestellten Ausführungsbeispiels näher erläutert.
Fig. 1 Unterseeboot mit erster Energiespeichervorrichtung
Fig. 2 Unterseeboot mit mehreren Energieerzeugern

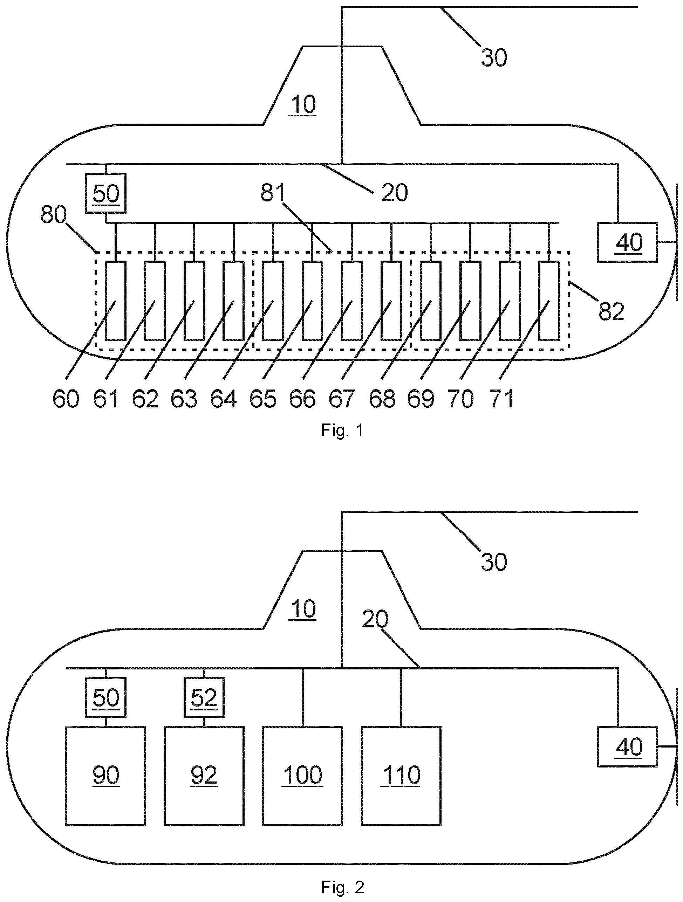

In Fig. 1 ist ein Unterseeboot 10 gezeigt. Dieses liegt beispielhaft im Hafen und über einen Landanschluss 30 wird das Bordnetz 20 mit Energie erzeugt. Als Verbraucher ist beispielhaft ein Fahrmotor 40 gezeigt. Mit dem Bordnetz über einen Trennschalter 50 verbindbar weist das Unterseeboot 10 eine Energiespeichervorrichtung 90 auf, welche 12 Stränge 60, 61, 62, 63, 64, 65, 66, 67, 68, 69, 70, 71 aufweist. Zur Durchführung des Verfahrens ist der Trennschalter 50 auf Trennen gestellt, sodass keine elektrische Verbindung zwischen der ersten Energiespeichervorrichtung 90 und dem Bordnetz 20 besteht.

Es wird zunächst beispielhaft eine gleichmäßige Ladung von ungefähr 50 % ± 5 % der maximalen Kapazität eingestellt, bevor die ersten Energiespeichervorrichtung 90 durch den Trennschalter 50 vom Bordnetz 20 getrennt wird (Schritt a)). Im Folgenden wird davon ausgegangen, dass alle Stränge exakt die gleiche Kapazität aufweisen und genau 50 % Anfangsladezustand eingestellt sind und während des Verfahrens keine elektrische Energie durch Verluste verloren wird, um die Betrachtung zu vereinfachen.

Gemäß Schritt b) werden der erste Strang 60, der zweite Strang 61, der dritte Strang 62 und der vierte Strang 63 in einer ersten Stranggruppe 80 zusammengefasst, der fünfte Strang 64, der sechste Strang 65, der siebente Strang 66 und der achte Strand 67 werden in einer zweiten Stranggruppe 81 zusammengefasst und der neunte Strang 68, der zehnte Strang 69, der elfte Strang 70 und der zwölfte Strang 71 werden in der dritten Stranggruppe 82 zusammengefasst.

Nun wird die erste Stranggruppe 80 zur Überprüfung der realen maximalen Kapazität ausgewählt (Schritt c)).

Nun werden in Schritt d) alle Stränge 60, 61, 62, 63 der ersten Stranggruppe 80 vollständig geladen (somit auf 100 %) und die Energie von den Stränge 64, 65, 66, 67, 68, 69, 70, 71 der zweiten Stranggruppe 81 und der dritten Stranggruppe 82 entnommen, die damit einen Ladezustand von 25 % haben. Anschließend wird in Schritt e) die volle Ladung für eine vorgegebene Zeit, beispielsweise 5 Minuten, gehalten.

Nun werden in Schritt f) alle Stränge 60, 61, 62, 63 der ersten Stranggruppe 80 vollständig entladen (somit auf 0 %) und die Energie auf die Stränge 64, 65, 66, 67, 68, 69, 70, 71 der zweiten Stranggruppe 81 und der dritten Stranggruppe 82 übertragen, die damit einen Ladezustand von 75 % haben. Dieses erfolgt bevorzugt mit einem konstanten Strom, beispielsweise 20 % des maximalen Stromes. Dieser Strom wird für jeden Strang 60, 61, 62, 63 durch dessen Strang-Batteriemanagementsystems erfasst. Hierdurch kann nun die echte Kapazität jedes einzelnen Stranges 60, 61, 62, 63 der ersten Stranggruppe 80 ermittelt werden.

Anschließend werden in Schritt g) alle Stränge 60, 61, 62, 63 der ersten Stranggruppe 80 wieder auf 50 % geladen und die Energie von den Stränge 64, 65, 66, 67, 68, 69, 70, 71 der zweiten Stranggruppe 81 und der dritten Stranggruppe 82 entnommen, die damit einen Ladezustand von ebenfalls 50 % haben.

Ist nun die Liegezeit des Unterseebootes 10 beendet, so kann dieses auslaufen. Verbleibt das Unterseeboot 10 jedoch noch im Hafen, wird vorzugsweise auch die zweite Stranggruppe vermessen. Alternativ kann dieses beim nächsten Hafenaufenthalt erfolgen. Ist noch Zeit, so wird die zweite Stranggruppe 81 zur Überprüfung der realen maximalen Kapazität ausgewählt (Schritt h)).

Nun werden in Schritt i) alle Stränge 64, 65, 66, 67 der zweiten Stranggruppe 81 vollständig geladen (somit auf 100 %) und die Energie von den Stränge 60, 61, 62, 63, 68, 69, 70, 71 der ersten Stranggruppe 80 und der dritten Stranggruppe 82 entnommen, die damit einen Ladezustand von 25 % haben. Anschließend wird in Schritt j) die volle Ladung für eine vorgegebene Zeit, beispielsweise 5 Minuten, gehalten.

Nun werden in Schritt k) alle Stränge 64, 65, 66, 67 der zweiten Stranggruppe 81 vollständig entladen (somit auf 0 %) und die Energie auf die Stränge 60, 61, 62, 63, 68, 69, 70, 71 der ersten Stranggruppe 80 und der dritten Stranggruppe 82 übertragen, die damit einen Ladezustand von 75 % haben. Dieses erfolgt bevorzugt mit einem konstanten Strom, beispielsweise 20 % des maximalen Stromes. Dieser Strom wird für jeden Strang 64, 65, 66, 67 durch dessen Strang-Batteriemanagementsystems erfasst. Hierdurch kann nun die echte Kapazität jedes einzelnen Stranges 64, 65, 66, 67 der zweiten Stranggruppe 81 ermittelt werden.

Anschließend werden in Schritt l) alle Stränge 64, 65, 66, 67 der zweiten Stranggruppe 81 wieder auf 50 % geladen und die Energie von den Stränge 60, 61, 62, 63, 68, 69, 70, 71 der ersten Stranggruppe 80 und der dritten Stranggruppe 82 entnommen, die damit einen Ladezustand von ebenfalls 50 % haben.

Wenn keine Zeit mehr ist, kann nun das Unterseeboot 10 auslaufen. Ist jedoch noch Zeit, wird das Verfahren für die dritte Stranggruppe 82 fortgesetzt. Ist noch Zeit, so wird die dritten Stranggruppe 82 zur Überprüfung der realen maximalen Kapazität ausgewählt.

Nun werden alle Stränge 68, 69, 70, 71 der zweiten Stranggruppe 81 vollständig geladen (somit auf 100 %) und die Energie von den Stränge 60, 61, 62, 63, 64, 65, 66, 67 der ersten Stranggruppe 80 und der zweiten Stranggruppe 81 entnommen, die damit einen Ladezustand von 25 % haben. Anschließend wird die volle Ladung für eine vorgegebene Zeit, beispielsweise 5 Minuten, gehalten.

Nun werden alle Stränge 68, 69, 70, 71 der dritten Stranggruppe 82 vollständig entladen (somit auf 0 %) und die Energie auf die Stränge 60, 61, 62, 63, 64, 65, 66, 67 der ersten Stranggruppe 80 und der zweiten Stranggruppe 81 übertragen, die damit einen Ladezustand von 75 % haben. Dieses erfolgt bevorzugt mit einem konstanten Strom, beispielsweise 20 % des maximalen Stromes. Dieser Strom wird für jeden Strang 68, 69, 70, 71 durch dessen Strang-Batteriemanagementsystems erfasst. Hierdurch kann nun die echte Kapazität jedes einzelnen Stranges 68, 69, 70, 71 der dritten Stranggruppe 82 ermittelt werden.

Anschließend werden alle Stränge 68, 69, 70, 71 der dritten Stranggruppe 82 wieder auf 50 % geladen und die Energie von den Stränge 60, 61, 62, 63, 64, 65, 66, 67 der ersten Stranggruppe 80 und der zweiten Stranggruppe 81 entnommen, die damit einen Ladezustand von ebenfalls 50 % haben.

Fig. 2 zeigt das Unterseeboot 10 mit weiteren Komponenten. Die erste Energiespeichervorrichtung 90, welche in Fig. 1 mit ihren Strängen 60, 61, 62, 63, 64, 65, 66, 67, 68, 69, 70, 71 dargestellt ist, ist in Fig. 2 nur als eine Einheit gezeigt. Zusätzlich weist das Unterseeboot 10 eine zweite Energiespeichervorrichtung 92 auf, die über einen Trennschalter 52 mit dem Bordnetz 20 verbindbar ist. Weiter weist das Unterseeboot 10 eine Brennstoffzellenvorrichtung 100 und einen Dieselgenerator 110 auf, die neben oder alternativ zum Landanschluss 30 die Energieversorgung des Bordnetzes 20 übernehmen können. Alternativ kann die zweite Energiespeichervorrichtung 92 das Bordnetz versorgen, während die erste Energiespeichervorrichtung 90 das erfindungsgemäße Verfahren durchführt oder anders herum.

### Bezugszeichen

- 10: Unterseeboot
- 20: Bordnetz
- 30: Landanschluss
- 40: Fahrmotor
- 50: Trennschalter
- 52: Trennschalter
- 60: erster Strang
- 61: zweiter Strang
- 62: dritter Strang
- 63: vierter Strang
- 64: fünfter Strang
- 65: sechster Strang
- 66: siebter Strang
- 67: achter Strang
- 68: neunter Strang
- 69: zehnter Strang
- 70: elfter Strang
- 71: zwölfter Strang
- 80: erste Stranggruppe
- 81: zweite Stranggruppe
- 82: dritte Stranggruppe
- 90: erste Energiespeichervorrichtung
- 92: zweite Energiespeichervorrichtung
- 100: Brennstoffzellenvorrichtung
- 110: Dieselgenerator

## Patentansprüche

1. Verfahren zur Ermittlung des Alterungszustands (State of Health) einer Energiespeichervorrichtung (90, 92) an Bord eines Unterseebootes (10), wobei das Unterseeboot (10) wenigstens eine erste Energiespeichervorrichtung (90) aufweist, wobei die erste Energiespeichervorrichtung (90) mehr als zwei Stränge (60, 61, 62, 63, 64, 65, 66, 67, 68, 69, 70, 71) aufweist, **dadurch gekennzeichnet, dass** das Verfahren die folgenden Schritte aufweist:
a) Einstellen eines Ladezustands der ersten Energiespeichervorrichtung (90) auf einen Wert von 45 bis 80 % der maximalen Kapazität,
b) Aufteilen der Stränge (60, 61, 62, 63, 64, 65, 66, 67, 68, 69, 70, 71) auf Stranggruppen (80, 81, 82), wobei jede Stranggruppe (80, 81, 82) nicht mehr als 50 % der Stränge (60, 61, 62, 63, 64, 65, 66, 67, 68, 69, 70, 71) enthält,
c) Auswählen einer ersten Stranggruppe zur Ermittlung des Alterungszustandes,
d) Vollständiges Laden der ersten Stranggruppe (80),
e) Halten der ersten Stranggruppe (80) auf voller Ladung,
f) Vollständiges Entladen der ersten Stranggruppe (80) bei konstantem Strom und Erfassung der Kapazität der ersten Stranggruppe (80),
g) Laden der ersten Stranggruppe (80).

2. Verfahren nach Anspruch 1, **dadurch gekennzeichnet, dass** das Verfahren zusätzlich die folgenden Schritte aufweist:
h) Auswählen einer zweiten Stranggruppe (81) zur Ermittlung des Alterungszustandes,
i) Vollständiges Laden der zweiten Stranggruppe (81),
j) Halten der zweiten Stranggruppe auf voller Ladung,
k) Vollständiges Entladen der zweiten Stranggruppe (81) bei konstantem Strom und Erfassung der Kapazität der zweiten Stranggruppe (81),
l) Laden der zweiten Stranggruppe (81).

3. Verfahren nach Anspruch 2, **dadurch gekennzeichnet, dass** das Verfahren für alle weiteren Stranggruppen (80, 81, 82) fortgesetzt wird.

4. verranren nacn einem der vorstenenaen Ansprucne, **dadurch gekennzeichnet, dass** bei einem Fehler in einem Strang (60, 61, 62, 63, 64, 65, 66, 67, 68, 69, 70, 71) das Verfahren für die Stranggruppe (80, 81, 82) fortgesetzt wird und nur der betroffene Strang (60, 61, 62, 63, 64, 65, 66, 67, 68, 69, 70, 71) aus der Stranggruppe (80, 81, 82) genommen wird.

5. Verfahren nach einem der vorstehenden Ansprüche, **dadurch gekennzeichnet, dass** das die Stranggruppen (80, 81, 82) bis auf den ausgewählten Stranggruppe (80, 81, 82) in Schritt d) beziehungsweise Schritt i) die Energie zum vollständigen Aufladen des ausgewählten Stranggruppe (80, 81, 82) die Energie bereitstellen und in Schritt f) beziehungsweise in Schritt k) die Energie aus der ausgewählten Stranggruppe (80, 81, 82) aufnehmen.

6. Verfahren nach einem der vorstehenden Ansprüche, **dadurch gekennzeichnet, dass** die erste Energiespeichervorrichtung (90) vor dem Beginn des Verfahrens vom Bordnetz (20) des Unterseebootes (10) getrennt wird.

7. Verfahren nach einem der vorstehenden Ansprüche, **dadurch gekennzeichnet, dass** die Temperatur der ersten Energiespeichervorrichtung (90) in einem Bereich von 15 °C bis 35 °C gehalten wird.

8. Verfahren nach einem der vorstehenden Ansprüche, **dadurch gekennzeichnet, dass** die Schritte d) bis f) nach Schritt f) beziehungsweise die Schritte i) bis k) nach Schritt k) wiederholt werden.

9. Verfahren nach einem der vorstehenden Ansprüche, **dadurch gekennzeichnet, dass** das Unterseeboot (10) eine zweite Energiespeichervorrichtung (92) aufweist, wobei das Verfahren nach einem der vorherstehenden Ansprüche auch für die zweite Energiespeichervorrichtung (92) durchgeführt wird.

10. Verfahren nach Anspruch 9, **dadurch gekennzeichnet, dass** das Verfahren für die erste Energiespeichervorrichtung (90) und die zweite Energiespeichervorrichtung (92) gleichzeitig ausgeführt wird, während das Unterseeboot (10) über einen externen Anschluss von außen mit Energie versorgt wird.

11. Verfahren nach Anspruch 9, **dadurch gekennzeichnet, dass** das Verfahren für die erste Energiespeichervorrichtung (90) durchgeführt wird während die zweite Energiespeichervorrichtung (92) die Energieversorgung für das Unterseeboot (10) bereitstellt.

12. Verfahren nach einem der vorstehenden Ansprüche, **dadurch gekennzeichnet, dass** das Verfahren weder manuell noch automatisch durchgeführt werden kann, während sich das Unterseeboot (10) im Kampfmodus befindet.

13. Verfahren nach einem der vorstehenden Ansprüche, **dadurch gekennzeichnet, dass** Stränge (60, 61, 62, 63, 64, 65, 66, 67, 68, 69, 70, 71), welche einen Fehler oder Defekt aufweisen, bei der Aufteilung in Schritt b) nicht berücksichtigt werden und nicht für das Verfahren verwendet werden.

## Claims

1. Method for determining the state of health of an energy storage device (90, 92) on board a submarine (10), wherein the submarine (10) has at least one first energy storage device (90), wherein the first energy storage device (90) has more than two strings (60, 61, 62, 63, 64, 65, 66, 67, 68, 69, 70, 71), **characterised in that**, the method comprises the following steps:
a) setting a state of charge of the first energy storage device (90) to a value of 45 to 80 per cent of the maximum capacity,
b) dividing the strings (60, 61, 62, 63, 64, 65, 66, 67, 68, 69, 70, 71) into string groups (80, 81, 82), each string group (80, 81, 82) containing no more than 50% of the strings (60, 61, 62, 63, 64, 65, 66, 67, 68, 69, 70, 71),
c) selecting a first strand group for determining the ageing state,
d) Fully charging the first strand group (80),
e) Maintaining the first string group (80) at full charge,
f) Fully discharging the first string group (80) at a constant current and recording the capacity of the first string group (80),
g) charging the first string group (80).

2. Method according to claim 1, **characterised in that** , the method additionally comprises the following steps:
h) Selecting a second string group (81) for determining the ageing state,
i) Fully charging the second string group (81),
j) Maintaining the second string group at full charge,
k) Fully discharging the second string group (81) at a constant current and recording the capacity of the second string group (81),
I) charging the second string group (81) to full charge ( ).

3. Method according to claim 2, **characterised in that** the method is continued for all further string groups (80, 81, 82).

4. Method according to one of the preceding claims, **characterised in that,** in the event of a fault in a strand (60, 61, 62, 63, 64, 65, 66, 67, 68, 69, 70, 71), the method is continued for the strand group (80, 81, 82) and only the affected strand (60, 61, 62, 63, 64, 65, 66, 67, 68, 69, 70, 71) is removed from the strand group (80, 81, 82).

5. Method according to one of the preceding claims, **characterised in that** the energy for completely charging the selected strand group (80, 81, 82) is provided by the strand groups (80, 81, 82) except for the selected strand group (80, 81, 82) in step d) or step i), respectively, provide the energy for completely charging the selected string group (80, 81, 82) and, in step f) or step k), respectively, absorb the energy from the selected string group (80, 81, 82).

6. Method according to one of the preceding claims, **characterised in that** the first energy storage device (90) is disconnected from the on-board power supply (20) of the submarine (10) before the start of the method.

7. Method according to one of the preceding claims, **characterised in that** the temperature of the first energy storage device (90) is maintained within a range of 15 °C to 35 °C.

8. Method according to one of the preceding claims, **characterised in that** steps d) to f) are repeated after step f) and steps i) to k) are repeated after step k).

9. Method according to one of the preceding claims, **characterised in that** the submarine (10) has a second energy storage device (92), wherein the method according to one of the preceding claims is also performed for the second energy storage device (92).

10. Method according to claim 9, **characterised in that** the method is performed simultaneously for the first energy storage device (90) and the second energy storage device (92) while the submarine (10) is supplied with energy from outside via an external connection.

11. Method according to claim 9, **characterised in that** the method is performed for the first energy storage device (90) while the second energy storage device (92) provides the energy supply for the submarine (10).

12. Method according to one of the preceding claims, **characterised in that** the method cannot be performed either manually or automatically while the submarine (10) is in combat mode.

13. Method according to one of the preceding claims, **characterised in that** strands (60, 61, 62, 63, 64, 65, 66, 67, 68, 69, 70, 71) which have a fault or defect are not taken into account in the division in step b) and are not used for the method.

## Revendications

1. Procédé pour déterminer l'état de santé d'un dispositif de stockage d'énergie (90, 92) à bord d'un sous-marin (10), dans lequel le sous-marin (10) comporte au moins un premier dispositif de stockage d'énergie (90), dans lequel le premier dispositif de stockage d'énergie (90) comporte plus de deux chaînes (60, 61, 62, 63, 64, 65, 66, 67, 68, 69, 70, 71), **caractérisé en ce que** , le procédé comprend les étapes suivantes :
a) réglage d'un état de charge du premier dispositif de stockage d'énergie (90) à une valeur comprise entre 45 et 80 % de la capacité maximale,
b) diviser les chaînes (60, 61, 62, 63, 64, 65, 66, 67, 68, 69, 70, 71) en groupes de chaînes (80, 81, 82), chaque groupe de chaînes (80, 81, 82) ne contenant pas plus de 50 % des chaînes (60, 61, 62, 63, 64, 65, 66, 67, 68, 69, 70, 71),
c) sélectionner un premier groupe de brins pour déterminer l'état de vieillissement,
d) charger complètement le premier groupe de brins (80),
e) Maintenir le premier groupe de chaînes (80) à pleine charge,
f) Décharger complètement le premier groupe de chaînes (80) à un courant constant et enregistrer la capacité du premier groupe de chaînes (80),
g) charger le premier groupe de chaînes (80).

2. Procédé selon la revendication 1, **caractérisé en ce que** , le procédé comprend en outre les étapes suivantes :
h) Sélectionner un deuxième groupe de chaînes (81) pour déterminer l'état de vieillissement,
i) Charger complètement le deuxième groupe de chaînes (81),
j) Maintenir le deuxième groupe de chaînes à pleine charge,
k) décharger complètement le deuxième groupe de chaînes (81) à un courant constant et enregistrer la capacité du deuxième groupe de chaînes (81),
l) charger le deuxième groupe de chaînes (81) à pleine charge ( ).

3. Procédé selon la revendication 2, **caractérisé en ce que** le procédé est poursuivi pour tous les autres groupes de chaînes (80, 81, 82).

4. Procédé selon l'une des revendications précédentes, **caractérisé en ce que,** en cas de défaut dans un brin (60, 61, 62, 63, 64, 65, 66, 67, 68, 69, 70, 71), le procédé se poursuit pour le groupe de brins (80, 81, 82) et seul le câble concerné (60, 61, 62, 63, 64, 65, 66, 67, 68, 69, 70, 71) est retiré du groupe de câbles (80, 81, 82).

5. Procédé selon l'une des revendications précédentes, **caractérisé en ce que** l'énergie nécessaire pour charger complètement le groupe de brins sélectionné (80, 81, 82) est fournie par les groupes de brins (80, 81, 82) à l'exception du groupe de brins sélectionné (80, 81, 82) à l'étape d) ou à l'étape i), respectivement, fournissent l'énergie nécessaire pour charger complètement le groupe de brins sélectionné (80, 81, 82) et, à l'étape f) ou à l'étape k), respectivement, absorbent l'énergie provenant du groupe de brins sélectionné (80, 81, 82).

6. Procédé selon l'une des revendications précédentes, **caractérisé en ce que** le premier dispositif de stockage d'énergie (90) est déconnecté de l'alimentation électrique embarquée (20) du sous-marin (10) avant le début du procédé.

7. Procédé selon l'une des revendications précédentes, **caractérisé en ce que** la température du premier dispositif de stockage d'énergie (90) est maintenue dans une plage comprise entre 15 °C et 35 °C.

8. Procédé selon l'une des revendications précédentes, **caractérisé en ce que** les étapes d) à f) sont répétées après l'étape f) et les étapes i) à k) sont répétées après l'étape k).

9. Procédé selon l'une des revendications précédentes, **caractérisé en ce que** le sous-marin (10) comporte un deuxième dispositif de stockage d'énergie (92), le procédé selon l'une des revendications précédentes étant également mis en œuvre pour le deuxième dispositif de stockage d'énergie (92).

10. Procédé selon la revendication 9, **caractérisé en ce que** le procédé est mis en œuvre simultanément pour le premier dispositif de stockage d'énergie (90) et le deuxième dispositif de stockage d'énergie (92) tandis que le sous-marin (10) est alimenté en énergie depuis l'extérieur via une connexion externe.

11. Procédé selon la revendication 9, **caractérisé en ce que** le procédé est mis en œuvre pour le premier dispositif de stockage d'énergie (90) tandis que le deuxième dispositif de stockage d'énergie (92) assure l'alimentation en énergie du sous-marin (10).

12. Procédé selon l'une des revendications précédentes, **caractérisé en ce que** le procédé ne peut être mis en œuvre ni manuellement ni automatiquement pendant que le sous-marin (10) est en mode combat.

13. Procédé selon l'une des revendications précédentes, **caractérisé en ce que** les brins (60, 61, 62, 63, 64, 65, 66, 67, 68, 69, 70, 71) qui présentent un défaut ou une anomalie ne sont pas pris en compte dans la division à l'étape b) et ne sont pas utilisés pour le procédé.
